# EUROPÄISCHE PATENTANMELDUNG

(11) **EP 3 599 723 A1**
(43) Veröffentlichungstag der Anmeldung: **29.01.2020**
(21) Anmeldenummer: 18185589.1
(22) Anmeldetag: 25.07.2018
(51) Int. Cl.: H03M 3/00

(54) **SCHALTUNG ZUR PULSWEITENMODULATION**

(71) Anmelder: FRAUNHOFER-GESELLSCHAFT zur Förderung der angewandten Forschung e.V., 80686 München (DE)
(72) Erfinder: Hackner, Michael, 93155 Hemau OT Haag (DE)
(74) Vertreter: Pfitzner, Hannes

(57) **Zusammenfassung**

Eine Schaltung zur Pulsweitenmodulation umfasst einen Pulsweitenmodulator, der einen Ringoszillator und eine Ausgangslogik aufweist. Der Ringoszillator umfasst eine Vielzahl an Verzögerungsgliedern, wobei jedes Verzögerungsglied zumindest ein invertierendes Element aufweist. Die Ausgangslogik ist ausgebildet, um in Abhängigkeit von einem Multi-Bit-Signal Ausgangssignale der invertierenden Elemente in kombinierter Form abzugreifen, um das pulsweitenmodulierte Signal bereitzustellen, so dass die Pulsweiten des pulsweitenmodulierten Signals von dem Multi-Bit-Signal abhängig sind.

## Beschreibung

Ausführungsbeispiele der vorliegenden Erfindung beziehen sich auf eine Schaltung zur Pulsweitenmodulation (PWM). Weitere Ausführungsbeispiele beziehen sich auf ein entsprechendes Verfahren zur Ansteuerung der Schaltung sowie auf ein Computerprogramm. Bevorzugte Ausführungsbeispiele beziehen sich auf einen PWM-Generator, z. B., in Kombination mit einem Delta-Sigma-Modulator oder einer anderen Schaltung, wie z. B. einem Subapproximations-DA-Wandler zur Bereitstellung eines Signals.

Beim Delta-Sigma-Modulator-DAC (DSM-DAC) geht es darum, aus einer digitalen Folge von Werten mit definierter Bit-Breite (Pulse Code Modulation = PCM) ein möglichst genaues analoges Signal zu generieren. Delta-Sigma-Modulatoren in der Verwendung als Digital-Analog-Wandler (DSM-DACs) ermöglichen das Bereitstellen eines pulsweitenmodulierten Signals. Verwendung finden solche DSM-DACs vor allem in Audio-Systemen und elektrischen Motoren (Umrichter-Antriebe).

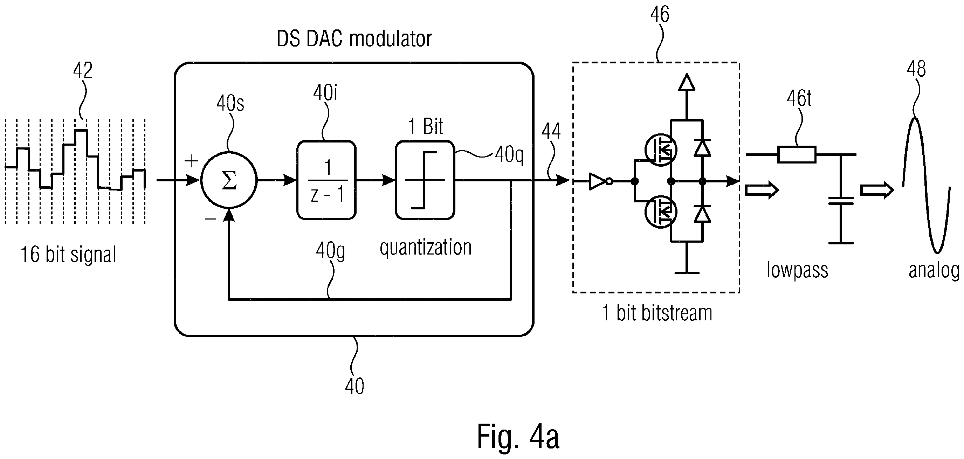

Fig. 4a stellt ein DSM-DAC (1 Bit, 1. Ordnung) mit Tiefpass (oft auf LC-TP) dar, wie er bei https://wwwmissinglinkelectronics.com/devzone/indexphp/source-menu-ioconnect-dac offenbart ist. Wie in Fig. 4a dargestellt, erhält der DSM-DAC 40 ein Eingangssignal 42, wie z. B. ein digitales 16 Bit-Signal. Dieses Signal wird mit dem 1 Bit-Quantisierer 40q quantisiert und dann ausgegeben. Da diese Quantisierung zunächst eine grobe Messung ist, entsteht ein Messfehler, der durch die Gegenkopplung 40g in Verbindung mit dem Summenelement 40s in dem Integrator 40e aufintegriert wird. Durch diese Gegenkopplung erfolgt eine Überabtastung einer entsprechenden Überabtastrate, so dass der Messfehler schrittweise kompensiert wird und ein digitales 1 Bit-Signal 44 (1 Bit-Bitstream) ausgegeben werden kann. Die Überabtastung (oversampling rate, OSR) ist sehr viel größer als 1 und hängt im Regelfall von der Auflösung ab. Werte von einer 128-fachen Rate der normalen Abtastrate oder eine Oversampling-Rate von 2¹⁶ sind normal.

Das overgesampelte 1 Bit-Signal 44 kann zur Pulsweitenmodulation verwendet werden, z. B. um eine Class-D-Endstufe 46 anzutreiben. Diese (Class-D-)Endstufe 46 ist nachgeschaltet und setzt direkt das 1 Bit-Signal 44 um und gibt das Signal über den optionalen Tiefpassfilter 46t ein Analogsignal 48 aus. Aufgrund der hohen Oversamplig-Rate ist F_{CLK} des 1 Bit-Bitstroms sehr groß, was dazu führt, dass die Endstufe 46 sehr viele Schaltvorgänge durchführen muss. Hieraus resultieren hohe Schaltverluste in der Leistungsstufe 46.

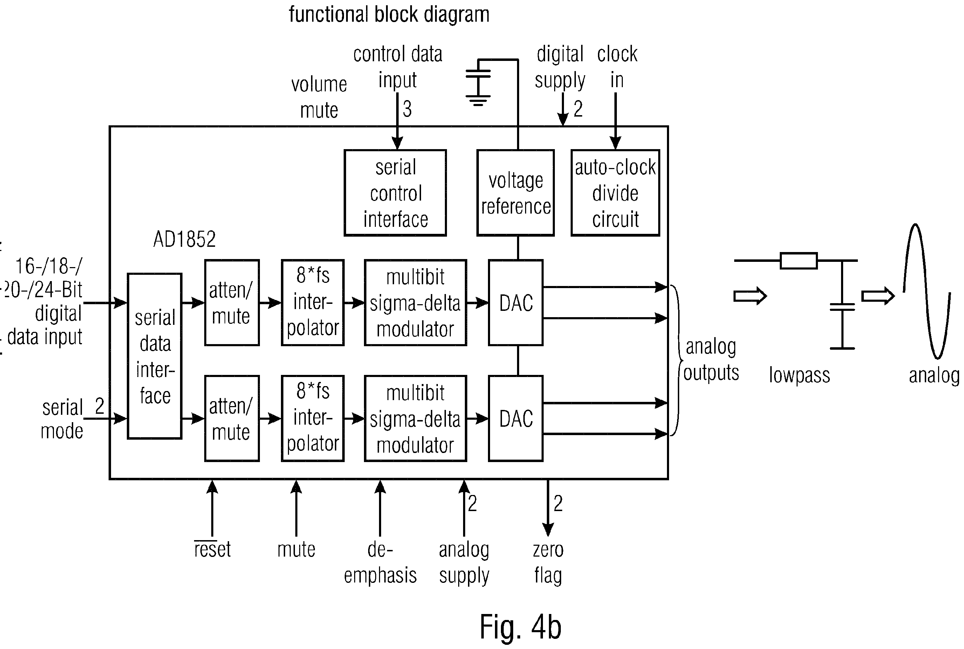

In Fig. 4b ist ein DSM-DAC dargestellt, der ausgehend von einer L-ten Ordnung ein Mbit-Signal ausgibt (Quelle: http://www.analogxom/media/en/technical-documentation/datasheets/AD1$52,pdf). Dieses Mbit-Signal ermöglicht die Verwendung von geringeren Oversampling-Raten, so dass geringere Schaltverluste in einer nachgelagerten Leistungsstufe erreicht werden. Zum Hintergrund: Eine Reduktion der Takt-Frequenz -und damit der Schaltverluste im Leistungsteil- ist beim Delta-Sigma-Prinzip möglich indem die Ordnung des Schleifenfilters erhöht wird. Beim 1 Bit DSM-DAC ist dann immer noch die direkte Ansteuerung einer Class-D Leistungs-Stufe möglich. Noch deutlich bessere Ergebnisse werden jedoch erzielt, wenn gleich zeitig auch die Anzahl der QuantisierungsStufen am Ausgangs von 2 (1 Bit) auf größer Zahlen erhöht wird. Wird dies durch einen DAC umgesetzt (siehe z.B. AD1852), dann wird jedoch der Vorteil der Class-D AusgangsStufe (Hoher Wirkungsgrad) zumindest zum Teil wieder aufgegeben. Weiter hat die hier dargestellte Variante den Nachteil höherer resultierende Querströme im DAC bzw. der Leistungsstufe.

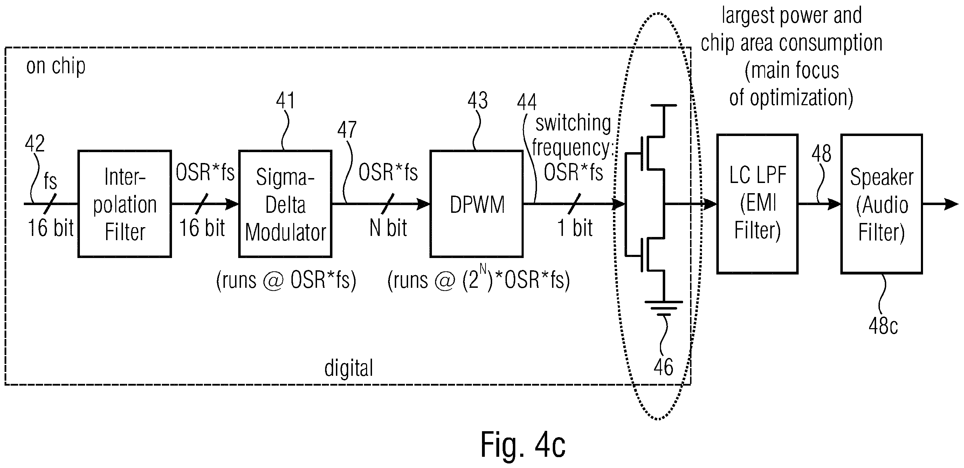

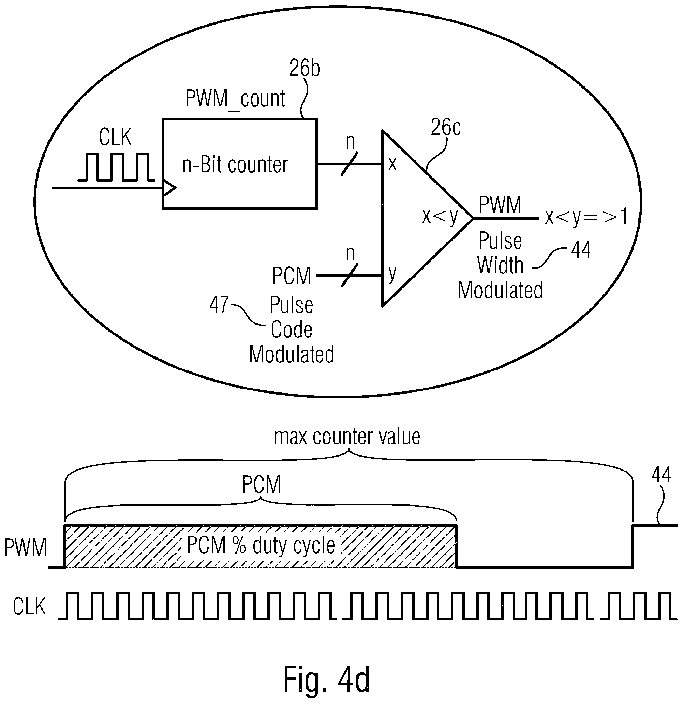

Fig. 4c zeigt ein weiteres Stand der Technik-Beispiel (vgl. Veröffentlichung von Pracný, Peter ; Bruun, Erik; Andersen, Michael A. E. mit dem Titel "Design considerations for a digital audio Class D output stage with emphasis on hearing aid application"), bei welchem ausgehend von einem 16 Bit-Signal 44 ein Delta-Sigma-Modulator N-ter Ordnung mit digitaler Pulsweitenmodulation (DPWM) verwendet wird. Hierzu ist die DPWM-Stufe 43 dem Sigma-Delta-Modulator 41 nachgeschaltet. Der Sigma-Delta-Modulator 41 gibt in diesem Ausführungsbeispiel ein Mbit-Signal an die DPWM-Stufe 43 (digitale Puslweitenmodulations-Stufe) aus. Diese ist ausgebildet, um ausgehend von dem Mbit-Signal ein 1 Bit-Signal am Ausgang zu erzeugen, so dass die Leistungsstufe, z. B. der Class-D-Verstärker 46 betrieben werden kann. Die DPWM-Stufe 43 kann beispielsweise, wie in Fig. 4d dargestellt, realisiert sein. Der Vollständigkeit halber sei angemerkt, dass nach der Leistungsstufe 46 auch noch zusätzlich Einheiten, wie z. B. ein LC-Tiefpassfilter 46f vorgesehen sein kann, so dass dann im Resultat ein analoges Signal 48, wie z. B. an den Lautsprecher 48l (Audiofilter) ausgegeben werden kann.

Die DPWM-Stufe 26 aus Fig. 4d umfasst einen Komparator 26c, der das PCM-Signal 47 (Puls-Code-moduliertes Signal) mit einem Countsignal von einem Bit-Counter 26b, der über eine Clock CLK betrieben wird, vergleicht. Wenn das PCM-Signal 47 (Y) größer als das Signal (X) des Mbit-Counters 26b ist, wird durch den Komparator 26c eine logische 1 ausgegeben. Dieses Ausgabesignal stellt das pulsweitenmodulierte Signal 44 dar. Also wird bei der digitalen PWM-Erzeugung ein Zähler in jedem DSM-Zyklus von 0 hochgezählt und mit dem PCM-Code verglichen. So lange der Zählerstand kleiner als der PCM-Code ist wird eine 1 ausgegeben, danach eine 0. Der Takt für den Zähler muss dabei fz=fs*2^N sein, wenn N die Auflösung der PWM in Bit ist. Soll die PWM 3 Bit Auflösung haben, dann muss der Takt für den Zähler 8-ma! so hoch sein, wie der Takt des DSM-DACs. Zur Verdeutlichung dieses Prinzips wird das pulsweitenmodulierte Signal 44 gegenüber dem Clock-Signal aufgetragen. Wie hier zu erkennen ist, wird durch den simplen Vergleich (Clock-Signals mit dem N-Bit-Signal 47) direkt ein pulsweitenmoduliertes Signal 44 generiert, das im Vergleich zu dem im Zusammenhang mit Fig. 4a diskutierten pulsweitenmodulierten Signal 44 (vgl. 1 Bit-Bitstrom) eine wesentlich niedrigere Frequenz F_{CLK} aufweist. In der Konsequenz werden eine wesentlich geringere Oversampling-Rate und dadurch auch geringere Schaltverlust in der nachgelagerten Leistungsstufe 46 reduziert. Auch werden die im Zusammenhang mit Fig. 4b erläuterten Querströme vermieden. Nachteilig ist weiter, dass in der DPWM-Stufe 26 eine erhöhte Taktfrequenz zur Pulsweitenmodulationssignalerzeugung benötigt wird. Deshalb besteht der Bedarf nach einem verbesserten Ansatz.

Aufgabe der vorliegenden Erfindung ist es ein Konzept für einen Pulsweitengenerator zu schaffen, das bezüglich der oben erläuterten Nachteile verbessert ist.

Die Aufgabe wird durch die unabhängigen Patentansprüche gelöst.

Ausführungsbeispiele der vorliegenden Erfindung schaffen eine Schaltung zur Pulsweitenmodulation mit einem Pulsweitenmodulator. Der Pulsweitenmodulator umfasst einen Ringoszillator sowie eine Ausgangslogik. Der Ringoszillator umfasst eine Vielzahl an Verzögerungsgliedern, wobei jedes Verzögerungsglied zumindest ein invertierendes Element aufweist. Die Ausgangslogik ist ausgebildet, um in Abhängigkeit von einem (eingehenden) Multi-Bit-Signal Ausgangssignale von den invertierenden Elementen des Ringoszillators in kombinierter Form abzugreifen, um das pulsweitenmodulierte Signal bereitzustellen. Hierbei ist die Pulsweite des pulsweitenmodulierten Signals von dem Multi-Bit-Signal abhängig.

Entsprechend Ausführungsbeispielen wird das Multi-Bit-Signal z. B. von einem Delta-Sigma-Modulator oder einer anderen Schaltung, wie z. B. einem Subapproximations-DAC bereitgestellt, und zwar in Form eines N-Bit-Signals, so dass extreme Oversampling-Raten nicht erforderlich sind.

Ausführungsbeispielen der vorliegenden Erfindung liegt die Erkenntnis zugrunde, dass die phasenverschobenen Ausgangssignale eines Ringoszillators durch eine geeignete Logik derart verknüpft werden können, so dass die Breite des Ausgangspulses im Verhältnis zur Periode des Signals dem N-Bit-Eingangssignal bzw. Puls-Code-moduliertem Wert (PCM-Signal) entspricht. Das PCM-Signal wird mittels Ansteuerung der Logik in das pulsweitenmodulierte Ausgangssignal übersetzt.

Entsprechend Ausführungsbeispielen weist die Ausgangslogik mindestens ein logisches Element, wie z. B. ein logisches "UND" oder ein logisches "UNDNICHT" auf. Dieses erste logische Element ist ausgebildet, um zwei Ausgangssignale von einem ersten und einem zweiten der invertierenden Elemente logisch miteinander zu verknüpfen, um ein resultierendes Signal bereitzustellen. Entsprechend weiteren Ausführungsbeispielen kann die Ausgangslogik neben dem ersten auch noch ein zweites invertierendes Element umfassen, das ausgebildet ist, zwei Ausgangssignale, z. B. von einem zweiten und einem dritten der invertierenden Elemente oder einem dritten und einem vierten der invertierenden Elemente logisch miteinander zu verknüpfen, um ein weiteres resultierendes Signal bereitzustellen. An dieser Stelle sei angemerkt, dass die invertierenden Elemente (erstes, zweites, drittes, viertes) entweder direkt hintereinander geschaltet sein können (aufeinanderfolgender Inverter) oder dass zwischen zwei invertierenden Elementen, z. B. einem ersten und einem zweiten invertierenden Element, die beispielsweise über das erste logische Element miteinander verknüpft sind, ein weiteres invertierendes Element vorgesehen sein kann (übernächster Inverter).

Bezüglich der Ausgangslogik sei angemerkt, dass bei einer Mehrzahl von logischen Elementen, d. h. also bei zwei logischen Elementen beispielsweise ein Multiplexer vorgesehen sein kann, der das resultierende Signal und das weitere resultierende Signal und eventuelle zusätzliche resultierende Signale auswählt und in kombinierter Form als pulsweitenmoduliertes Signal bereitstellt. Dieses Auswählen erfolgt in Abhängigkeit von dem Multi-Bit-Signal, um die Pulsweiten des pulsweitenmodulierten Signals zu steuern. Für den Fall, dass die Ausgänge bereits angewählt sind, kann die Abwahl über einen weiteren Multiplexer erfolgen. Dieser ist also ausgebildet, anliegende resultierende Signale von zumindest einem logischen Element abzuwählen, um das pulsweitenmodulierte Signal bereitzustellen bzw. zu beeinflussen bzw. um die Pulsweite zu begrenzen. Dieses Abwählen erfolgt wiederum entsprechend Ausführungsbeispielen in Abhängigkeit von dem Multi-Bit-Signal. Im Resultat wird also entsprechend Ausführungsbeispielen erreicht, dass durch Kombination oder Nicht-Kombination des resultierenden Signals des ersten logischen Elements und des weiteren resultierenden Signals des zweiten logischen Elements eine Pulsweite des pulsweitenmodulierten Signals beeinflusst wird. Dies basiert nämlich darauf, dass das resultierende Signal sowie das weitere resultierende Signal jeweils eine eigene Pulsweite hat, wobei das weitere resultierende Signal gegenüber dem resultierenden Signal phasenversetzt ist, so dass die Kombination dieser Signale die Pulsweite durch Aufsummieren oder Nicht-Aufsummieren beeinflussen kann.

Bezüglich der invertierenden Elemente sei angemerkt, dass diese entsprechend Ausführungsbeispielen durch einen Inverter, einen Operationsverstärker bzw. jeweils gegengepolter Operationsverstärker, ein NOR-Gatter, ein NAND-Gatter oder ähnliches gebildet sein kann. Im Allgemeinen ist das invertierende Element ausgebildet, um auf Basis eines Eingangssignals ein um 180° oder um 180 Grad + n x 360° verschobenes Ausgangssignal bereitzustellen. Die Verzögerung erfolgt entsprechend Ausführungsbeispielen durch das Verzögerungsglied oder insbesondere ein Verzögerungselement in dem Verzögerungsglied. Dieses kann entsprechend Ausführungsbeispielen als Kondensator ausgebildet sein. Entsprechend Ausführungsbeispielen ist die Anzahl an Verzögerungsgliedern (und damit auch an invertierenden Elementen) ungerade. Entsprechend weiteren Ausführungsbeispielen weist der Ringoszillator auch noch ein zusätzliches Und-Gatter auf, über welches beispielsweise das letzte invertierende Element mit dem ersten invertierenden Element verbunden ist. An dieser Stelle sei angemerkt, dass entsprechend weiteren Ausführungsbeispielen das Und-Gatter an einer beliebigen Stelle im Ringoszillator bzw. zwischen den hintereinandergeschalteten Verzögerungsgliedern angeordnet sein kann. Das Und-Gatter hält ein Enable-Signal und leitet folglich eine logische 1 nur dann weiter, wenn diese vom vorherigen Signal anliegt und das Enable-Signal anliegt, so dass durch das Enable-Signal der Startpunkt bzw. allgemein das Oszillieren des Ringoszillators festgelegt wird.

Bezüglich der Schaltung sei im Allgemeinen angemerkt, dass das Multi-Bit-Signal beispielsweise von einem Delta-Sigma-Modulator oder einer anderen Schaltung, wie z. B. einem Subapproximations-Digital-Analog-Wandler bereitgestellt sein kann. Deshalb umfasst entsprechend Ausführungsbeispielen die Schaltung einen Delta-Sigma-Modulator oder einen Subapproximations-Digital-Analog-Wandler oder eine ähnliche Schaltung. Entsprechend weiteren Ausführungsbeispielen umfasst die Schaltung eine nachgelagerte Endstufe, wie z. B. eine Class-D-Endstufe, die mit dem Ausgang des Pulsweitenmodulators gekoppelt ist, um durch das pulsweitenmodulierte Signal betrieben zu werden.

Ein weiteres Ausführungsbeispiel bezieht sich auf ein Verfahren zur Ansteuerung der Schaltung. Hierbei umfasst das Verfahren die Schritte Auswählen und/oder Abwählen eines oder mehrerer logischer Elemente der Ausgangslogik, um in Abhängigkeit von der Auswahl oder Abwahl des einen oder der mehreren logischen Elemente die resultierenden Signale in Kombination als das pulsweitenmodulierte Signal bereitzustellen. Hierbei erfolgt die Auswahl oder Abwahl in Abhängigkeit von dem eingehenden Multi-Bit-Signal. Dieses Verfahren kann entsprechend weiteren Ausführungsbeispielen durch ein Computerprogramm durchgeführt werden.

Weiterbildungen sind in den Unteransprüchen definiert. Es zeigen:
- Fig. 1: eine schematische Darstellung einer Schaltung zur Pulsweitenmodulation bzw. eines Pulsweitengenerators mit einem Pulsweitenmodulator umfassend einen Ringoszillator und eine Ausgangslogik gemäß Basisausführungsbeispielen;
- Fig. 2a: eine schematische Darstellung einer Schaltung mit einem Pulsweitenmodulator gemäß einem weiteren Ausführungsbeispiel;
- Fig. 2b: eine schematische Darstellung eines Ringoszillators gemäß einem Ausführungsbeispiel;
- Fig. 2c, 2d: schematische Darstellungen von Ausgangssignalen der invertierenden Elemente des Ringoszillators aus Fig. 2c sowie die resultierenden Signale der logischen Elemente der Ausgangslogik gemäß Ausführungsbeispielen;
- Fig. 3a: eine schematische Darstellung eines Ringoszillators mit einer Ausgangslogik gemäß Ausführungsbeispielen;
- Fig. 3b, 3c: schematische Darstellungen der Ausgangssignale des Ringoszillators bzw. der Ausgangslogik aus Fig. 3a;
- Fig. 3d: eine schematische Darstellung eines Ringoszillators gemäß einem erweiterten Ausführungsbeispiel;
- Fig. 3e, 3f: schematische Darstellungen der Ausgangssignale und resultierenden Signale ausgehend von dem Ringoszillator aus Fig. 3d;
- Fig. 4a-4d: schematische Darstellungen zur Illustration des Standes der Technik.

Bevor nachfolgend Ausführungsbeispiele der vorliegenden Erfindung anhand der beiliegenden Zeichnung erläutert werden, sei darauf hingewiesen, dass gleichwirkende Elemente und Strukturen mit gleichen Bezugszeichen versehen sind, so dass die Beschreibung derer aufeinander anwendbar bzw. austauschbar ist.

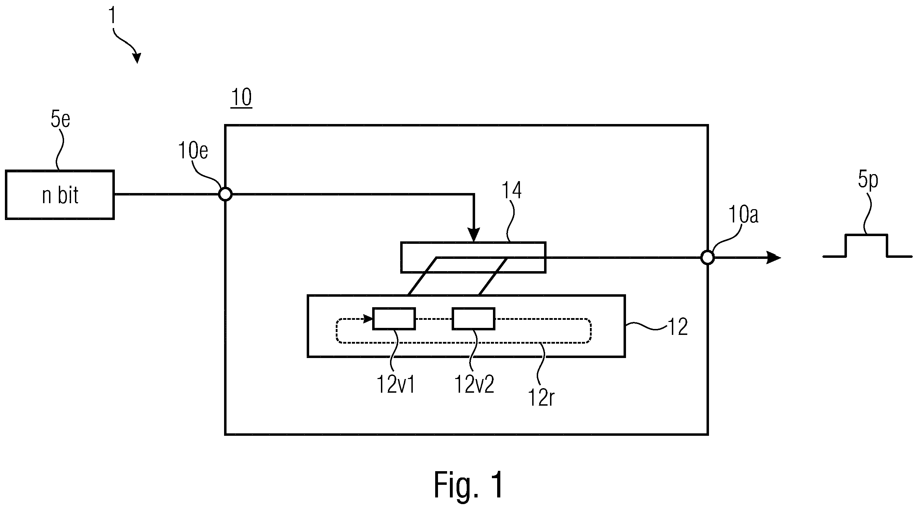

Fig. 1 zeigt eine Schaltung 1 mit einem Pulsweitenmodulator 10. Der Pulsweitenmodulator 10 umfasst die zwei Basiskomponenten Ringoszillator 12 und Ausgangslogik 14. Die Ausgangslogik 14 erhält über einen Eingang 10e des Pulsweitenmodulators ein Multi-Bit-Signal 5e. In Abhängigkeit von diesem Multi-Bit-Signal 5e ist die Ausgangslogik ausgebildet, um durch den Ringoszillator 12 generierte Signale abzugreifen und (z. B. in kombinierter Form) als pulsweitenmoduliertes Signal 5p über den Ausgang 10a bereitzustellen. Nachfolgend wird dieses Konzept im Detail erläutert.

Der Ringoszillator 12 umfasst eine Vielzahl an Verzögerungsgliedern, d. h. also zwei oder bevorzugterweise eine ungerade Vielzahl an Verzögerungsgliedern, wie z. B. drei, fünf oder sieben Verzögerungsglieder. In dieser Darstellung sind zwei Verzögerungsglieder 12v1 und 12v2 vorgesehen. Jedes dieser Verzögerungsglieder 12v1 und 12v2 umfasst zumindest ein invertierendes Element, wie z. B. ein Inverter, ein NAND- oder NOR-Gatter und auch einen differentiellen Verstärker, der gegenüber dem vorherigen differentiellen Verstärker des anderen Verzögerungsgliedes verpolt ist. Darüber hinaus kann jedes Verzögerungsglied 12v1 und 12v2 auch noch ein Verzögerungselement, wie z. B. einen Kondensator umfassen. Das Ausgangssignal des Verzögerungsgliedes 12v1 dient als Eingangssignal für das nachfolgende Verzögerungsglied 12v2. In dieser Nomenklatur setzt sich die Signalverbreitung innerhalb des Ringoszillators 12 bis zum letzten Verzögerungsglied fort, wobei dann das Ausgangssignal des letzten Verzögerungsgliedes (hier 12v2) als Eingangssignal für das erste Verzögerungsglied 12v1 dient. Dies ist durch den Rückkopplungspfad 12r dargestellt.

Durch jedes Verzögerungsglied 12v1, 12v2 bzw. ein Verzögerungselement des jeweiligen Verzögerungsglieds 12v1, 12v2 wird entsprechend Ausführungsbeispielen das Eingangssignal verzögert bzw. phasenversetzt, so dass also das Ausgangssignal des Verzögerungsgliedes 12v1 gegenüber dem Eingangssignal des Verzögerungsgliedes 12v1 leicht verschoben ist. Darüber hinaus erfolgt eine Invertierung durch das invertierende Element.

Wenn man nun das Eingangssignal und das Ausgangssignal der Verzögerungsglieder 12v1, 12v2 abgreift, wird man jeweils ein Rechtecksignal mit einer Pulsweite entsprechend der Phasenverschiebung erhalten. Durch die Kombination mehrerer derartige Rechtecksignale kann die Pulsweite entsprechend moduliert werden. Diese einzelnen Rechtecksignale um jedes Verzögerungselement 12v1 herum bzw. über mehrere Verzögerungsglieder 12v1 und 12v2 hinweg (z. B. Eingangssignal des invertierenden Verzögerungsgliedes 12v1 und Ausgangssignal des invertierenden Verzögerungssignals 12v2) werden durch die Ausgangslogik 14 als Ausgangssignale abgegriffen.

Die Ausgangslogik gibt entsprechend Ausführungsbeispielen in Abhängigkeit von der Ansteuerung eines der Ausgangssignale oder mehrere der Ausgangssignale in kombinierter Form aus, wobei dann hieraus eben das Pulsweitensignal 5p resultiert. Wird beispielsweise nur das Rechtecksignal über 12v1 abgegriffen, ist die Pulsweite des pulsweitenmodulierten Signales 5p kurz. Wird zusätzlich noch ein weiteres Rechtecksignal mit gleichen Vorzeichen um die Pulsweite des ersten Rechtecksignals phasenverschoben abgegriffen und kombiniert, so kann ein Pulsweitensignal 5p mit doppelter Pulsweite erhalten werden.

Wie bereits angedeutet, erfolgt entsprechend Ausführungsbeispielen die Steuerung der Ausgangslogik 14 in Abhängigkeit von dem Eingangssignal 5e.

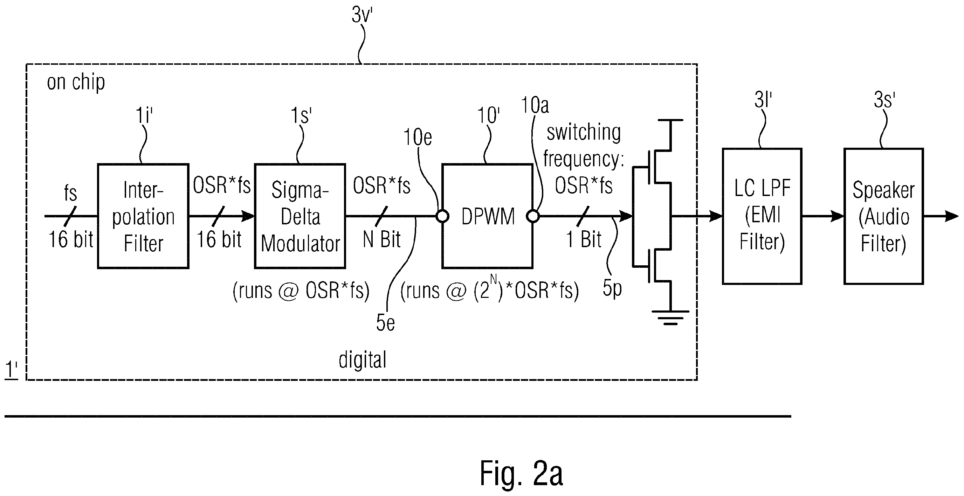

Nachfolgend wird Bezug nehmend auf Fig. 2a bis 2d ein weiteres Ausführungsbeispiel erläutert.

Fig. 2a zeigt eine Schaltung 1' mit einem digitalen Pulsweitenmodulator 10', der in diesem Ausführungsbeispiel von einem Sigma-Delta-Modulator 1s' ein Multi-Bit-Signal 5e erhält. Dieser Sigma-Delta-Modulator erhält beispielsweise ein 16-Bit-Signal als Eingangssignal, nämlich hier von einem optionalen Interpolationsfilter 1i'. Das 16-Bit-Signal wird mit der Sampling-Frequenz FS bei der Oversampling-Frequenz OSR von dem Interpolationsfilter 1i' auf Basis eines Eingangssignals (hier 16 Bit-FS als Sampling-Frequenz) erzeugt. Der digitale Pulsweitenmodulator 10' gibt dann ausgehend von dem Mbit-Signal das pulsweitenmodulierte Signal 5p als 1 Bit-Signal aus, und zwar an eine nachgelagerte Verstärkerstufe 3v'. Diese Verstärkerstufe 3v' kann beispielsweise ein Class-D-Stufe mit einem Transistorpaar sein. Am Ausgang der Verstärkerstufe 3v' ist ein optionaler LC-Tiefpassfilter 3l' angeordnet, der das verstärkte pulsweitenmodulierte Signal an den Leistungsempfänger, hier einen Lautsprecher 3s' weiterleitet. Dieser Lautsprecher kann direkt mit dem pulsweitenmodulierten Signal betrieben werden, da er als Filter fungiert und in Abhängigkeit von dem pulsweitenmodulierten Signal eine Schwingung erzeugt (Prinzip des Audiofilters).

Wie hier zu erkennen ist, wird der Sigma-Delta-Modulator 1s' bei FS x OSR betrieben und gibt das Ausgangssignal 5e ebenso mit OSR x FS aus. Diese Frequenz wird auch beibehalten, so dass die Endstufe 3v' ebenso mit einer Schaltfrequenz von FS x OSR betrieben werden kann, während der digitale Pulsweitenmodulator 10' eigentlich bei 2ⁿ x OSR x FS betrieben wird. Durch die im Zusammenhang mit Fig. 1 erläuterte Schaltung wird jedoch erreicht, dass nicht ein einzelnes Bit-Signal wie im Stand der Technik zum Betreiben der Verstärkerstufe 3v' ausgegeben wird, sondern ein entsprechenden pulsweitenmoduliertes Signal 5p.

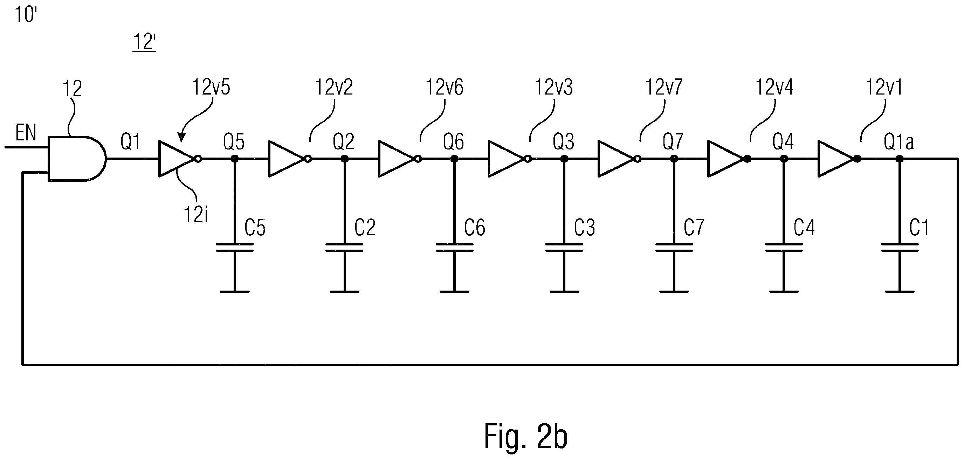

Bezugnehmend auf Fig. 2b wird nun der Pulsweitenmodulator 10' im Detail erläutert. Fig. 2b zeigt den Pulsweitenmodulator 10' und hierbei insbesondere den Ringoszillator 12'. Dieser umfasst die Verzögerungselemente 12v1 bis 12v7. Hierbei ist die Reihenfolge wie folgt gewählt. 12v5 vor 12v2, vor 12v6, vor 12v3, vor 12v7, vor 12v4, vor 12v1.

Jedes Verzögerungselement umfasst in diesem Ausführungsbeispiel einen Inverter 12i sowie eine Kapazität, die mit C1 bis C7 bzw. C5 bis C1 durchnummeriert ist. Diese Kapazitäten C1 bis C7 bzw. allgemein die Verzögerungselemente C1 bis C7 sind in diesem Ausführungsbeispiel am Ausgang jedes Inverters 12v1 bis 12v7 gegenüber Masse geschaltet, können aber auch anders verschaltet sein.

Am Ende jedes Inverters liegt das entsprechende Signal Q1 bis Q7 bzw. Q5 bis Q1a an, wobei Q1a das gleiche Signal wie Q1 darstellt, nur an einer anderen Position innerhalb des Ringoszillators 12' abgreifbar ist.

Jedes Signal Q1 bis Q7 verharrt im selben Zustand, bis der gesamte Ringoszillator einmal durchgeschaltet wurde (halber Duty-Cycle). Die Dauer eines Duty-Cycles bzw. halben Duty-Cycles hängt im Wesentlichen von den Kapazitäten C1 bis C7, die als Verzögerungselemente dienen ab. Durch das Invertieren und das Verwenden von einer ungeraden Anzahl an Verzögerungsgliedern 12v1 bis 12v7 ändert sich nach jedem halben Duty-Cycle der Signalzustand der Signale Q1 bis Q7.

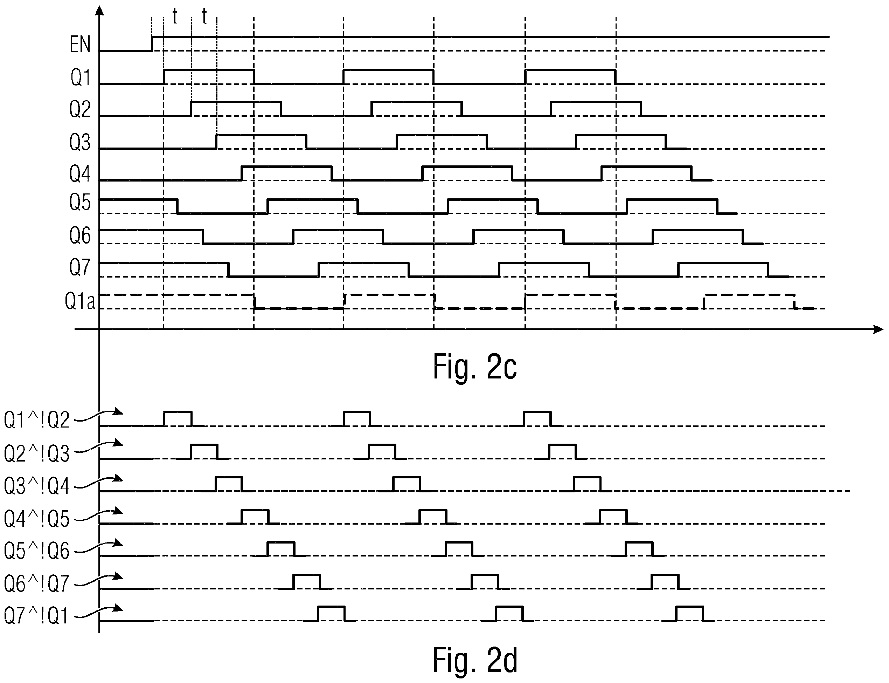

Im Ergebnis erzeugt der Ringoszillator 12' ein Rechteck-Signal mit ca. 50% Puls-Pausen-Verhältnis (Duty-Cycle), wobei jeder inverter eine >180° Phasen-Drehung macht (sodass nach jedem 2. Inverter ist das Rechteck-Signal um je 360°/M verschoben ist (M ist die Zahl der Inverter).
Frequenz des Ringoszillators ist gleich der Taktfrequenz des DSM-DACs, unabhängig von der PWM-Auflösung. Die entsprechenden Signale Q1 bis Q7 bzw. bis Q1a sind in Fig. 2c dargestellt.

Fig. 2c zeigt die einzelnen Signale an den Ausgängen Q1 bis Q7. Wie zu erkennen ist, ist das Ausgangssignal Q2 um eine Zeit t phasenverschoben gegenüber Q1, während Q3 wiederum um t phasenverschoben ist.

Durch das Abgreifen von einem Signal, z. B. Q1 über die nicht dargestellte Ausgangslogik kann am Ausgang des Pulsweitenmodulators 10' ein Pulsweitensignal 10p mit einer festen Pulsweite abgegriffen werden. Durch die Kombination dieses Signals Q mit weiteren Signalen, z. B. Nicht-Q2 (invertiertes Q2) ist die Pulsweite variierbar, wie hier anhand von Fig. 2d dargestellt ist. Fig. 2d zeigt eine Vielzahl an Signalen mit kurzer Pulsweite bzw. kurzem Ein-Puls. Diese Signale basieren beispielsweise auf der Kombination von Q1 mit Nicht-Q2 oder Q2 mit Nicht-Q3 oder Q3 mit Nicht-Q4 oder Q4 mit Nicht-Q5 oder Q5 mit Nicht Q6 oder Q6 mit Nicht-Q7 oder Q7 mit Nicht-Q1. Also wird durch geeignete kombinatorische Logik ein PWM-Signal mit M+1 Werten erzeugt.

Diese Kombinationssignale können wiederum, z. B. unter Zuhilfenahme eines Multiplexers der Ausgangslogik kombiniert werden, so dass beispielsweise die Q1-entsprechende Pulsweite durch die drei Signale Q1 kombiniert mit Nicht-Q2, Q2 kombiniert mit Nicht-Q3 und Q3 kombiniert mit Nicht-Q4 erhalten werden. Dieses Signal kann um seine Pulsweite verlängert werden indem beispielsweise nach Q4 kombiniert mit Nicht-Q5 hinzugefügt wird. Durch die entsprechende Variation ist also die Pulsweite des pulsweitenmodulierten Signals 5p anpassbar. Die Variation der Ausgangslogik erfolgt in Abhängigkeit von dem Multi-Bit-Signal 5e, so dass das pulsweitenmoduliertes Signal 5p mittels dem Multi-Bit-Signal 5e gesteuert wird.

Das Ausführungsbeispiel lässt sich in anderen Worten wie folgt beschreiben: Die Kombination Q<n> UND NICHT(Q<n+1>) erzeugt Pulse der Breite "1", wobei die weitere Logik Pulse zu einem Puls der Breite entsprechend dem PCM-Wert verknüpft:
- 0: Low
- 1: 1 Puls High dann Low
- 2: 2 Pulse High dann Low
- 3: 3 Pulse High dann Low
- 4: ...
- 7: 7 Pulse High => nur High!

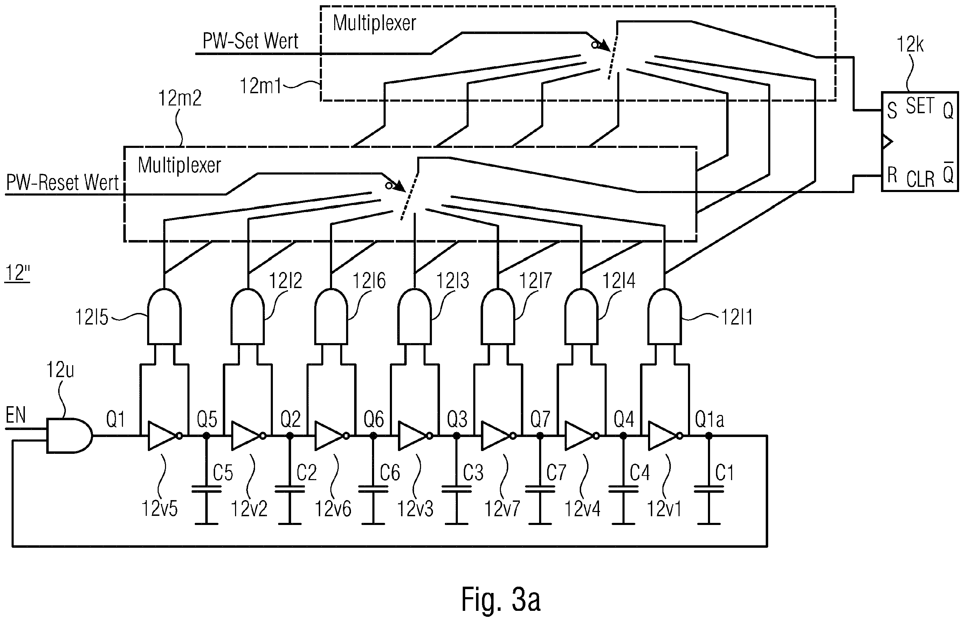

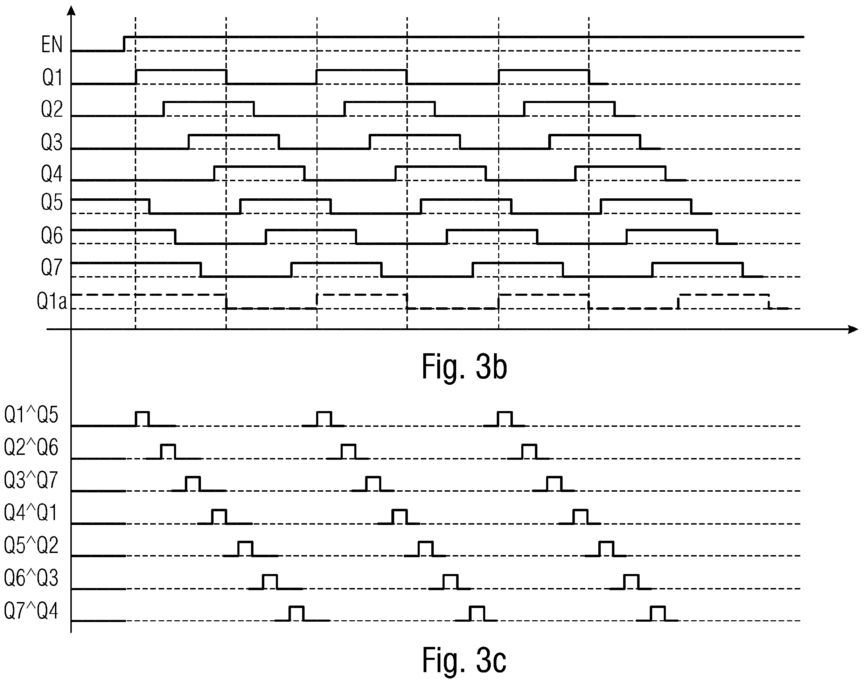

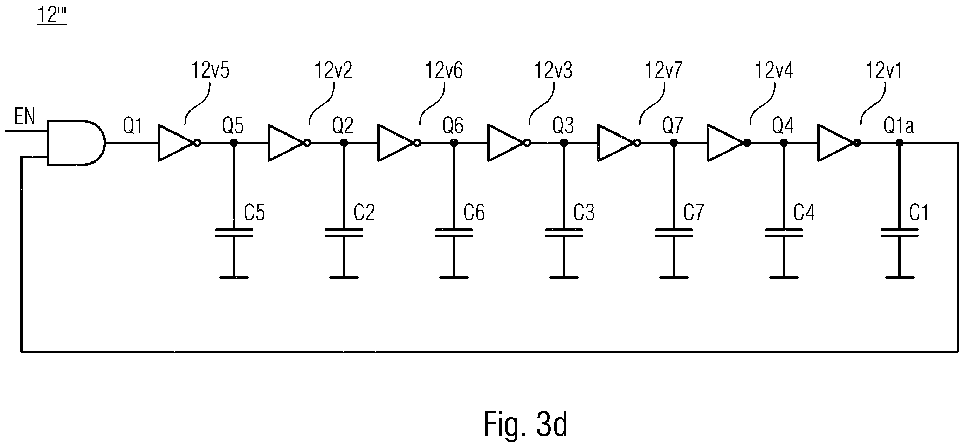

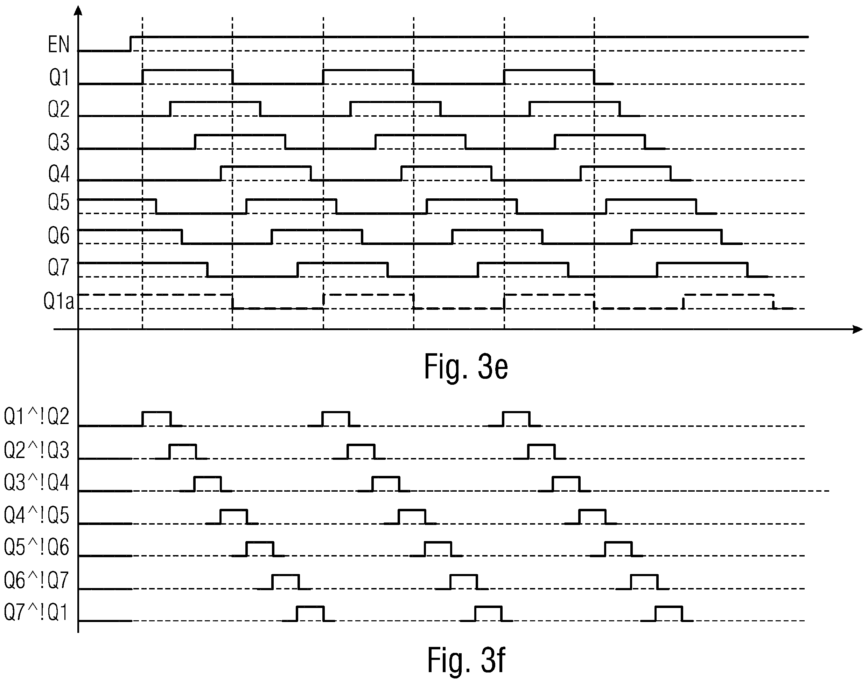

Bei geeigneter Implementierung kann zusätzlich auch die "Phasenlage" des PWM-Pulses in 360°/M-Schritten definiert werden.:
In diesem Ausführungsbeispiel wurde davon ausgegangen, dass immer zwei Ausgänge bzw. ein Ausgang mit einem invertierten Ausgang über eine Logik, wie z. B. ein logisches Element miteinander verknüpft sind. Ausgehend von sieben Verzögerungselementen werden also sieben Kombinationssignale als Ausgangssignal abgegriffen. Diese Ausgangssignale können dann, z. B. ohne Zuhilfenahme ein oder mehrerer Multiplexer miteinander kombiniert werden. Diese Multiplexer werden durch das Eingangssignal 5e gesteuert und Wählen die entsprechenden logischen Elemente an. An dieser Stelle sei angemerkt, dass die oben erläuterte Kombination der logischen Elemente und insbesondere auch die Anordnung der Verzögerungsglieder 12v1 bis 12v7 (mit immer einem weiteren Verzögerungsglied zwischen zwei zu kombinierenden Verzögerungsgliedern (12v6 zwischen 12v2 und 12v3 bzw. Q6 zwischen Q2 und Q3)) der Ausgangslogik 12 rein demonstrativ ist, wobei Bezug nehmend auf Fig. 3 noch eine weitere Variante erläutert werden wird.

An dieser Stelle sei weiter angemerkt, dass zwischen dem Verzögerungsglied 12v1 (letzte Verzögerungsglied) und dem Verzögerungsglied 12v5 (erstes Verzögerungsglied bei der Anordnung des Ringoszillators 12' auch noch ein weiteres Gatter, nämlich ein UND-Gatter 12u vorgesehen sein kann. Dieses Und-Gatter leitet das Signal Q1a (entsprechend Q1) an 12v5 weiter, wenn ein positives Enable-Signal (En) an dem Und-Gatter 12 anliegt. Durch dieses Enable-Signal ist der Beginn jedes Duty-Cycles bzw. alle Duty-Cycle definierbar, wie in Anbetracht von Fig. 2c klar wird. Hintergrund hierzu ist, dass beispielsweise das Signal Q1 dem Enable-Signal En nacheilt, da erst bei Anliegen des Enable-Signals En das Signal Q1 von dem Und-Gatter 12u ausgegeben werden kann.

Bezugnehmend auf die Gesamtfunktion der in Fig. 2 dargestellten Schaltung sei angemerkt, dass jedes der hier dargestellten invertierenden Elemente der Verzögerungsglieder 12v1 bis 12v7 wirkt als Phasenschieben. Durch die ungerade Anzahl schwingt das System, da bei einem Durchlauf (d.h. an dem optionalen UND-Gatter 12u bzw. nach durchlauf des Rückkopplungspfads) genau den invertierten Signalzustand im Vergleich zu dem vorherigen Durchlauf aufweist. An dieser Stelle sei auch angemerkt, dass die Anzahl der Verzögerungsglieder 12v1 bis 12v7 die Auflösung des Pulsweitenmodulators bestimmt.

Fig. 3a zeigt eine weitere Implementierung des Inverters, nämlich dem Ring-Inverter 12". Bei diesem Inverter sind ebenfalls sieben Verzögerungsglieder 12v1 bis 12v7 angeordnet, wobei hier die Reihenfolge wie folgt vorgesehen ist. 12v5 vor 12v2 vor 12v6 vor 12v3 vor 12v7 vor 12v4 vor 12v1. Als eine Rückkopplungsschleife zwischen 12v1 und 12v5 ist wiederum das Und-Gatter 12u angeordnet. Bei diesem Ausführungsbeispiel sind allerdings nicht die der Nomenklatur nach hintereinander angeordneten Ausgänge bzw. Ausgänge mit einem entsprechenden invertierten Ausgang miteinander verknüpft, sondern immer der Ein- und Ausgang für jedes Verzögerungsglied 12v1 bis 12v7. Folglich wird also verknüpft Q1 mit Q5, Q2 mit Q6, Q3 mit Q7, Q4 mit Q1, Q5 mit Q2, Q6 mit Q3 und Q7 mit Q4. Die Verschaltung erfolgt durch die logischen Elemente 12l1 bis 12l7. Beispielsweise greift 12l5 die Signale Q1 in Kombination mit Q5 ab. 12l3 greift beispielsweise die Kombinationen Q6 und Q3 ab. Bei dieser Variante dient der jeweilige Inverter im Ring selbst der Invertierung des nachfolgenden Signals, so dass es nicht notwendig ist, wie bei Fig. 2a-2d erläutert eine zusätzliche Invertierung des zweiten durch das logische Element abgegriffenen Signals (Nicht-Qx) durchzuführen.

Ausgehend von den jeweiligen Signalen Q1 bis Q7, die in Fig. 3b dargestellt sind entstehen die oben erläuterten logischen Signalkombinationen, die in Fig. 3c dargestellt sind.

Diese Signalkombinationen werden durch den Multiplexer angewählt, nämlich über das PW-Reset-Signal. Eine Abwahl des jeweiligen Eingangs kann dann über den zweiten Multiplexer 12m2 ausgehend von dem PW-Reset-Signal erfolgen. Die über die Multiplexer 12m1 und 12m2 abgegriffenen Signale werden durch die Einheit 12k kombiniert, so dass durch 12k das PWM Signal 5p bereitgestellt wird. Diese in Fig. 3a bis 3c erläuterte Variante bietet den Vorteil, dass die einzelnen Ausgangssignale ausgehend von der Kombination (vgl. Fig. 3c) eine wesentliche kürzere Pulsweite haben, als die Pulsweiten aus Fig. 2d. Das Verwenden der Ausgänge von aufeinanderfolgenden Invertern bietet also den Vorteil, dass die Pulse kürzer sind und so bei gleichbleibender Effizienz ein hochauflösenderes Signal erreicht werden kann.

Fig. 3d stellt einen weiteren Ringoszillator 12'" dar, bei welchem die sieben invertierenden Verzögerungsglieder 12v1-12v7 wie folgt angeordnet sind: 12v5 vor 12v2 vor 12v6 vor 12v3 vor 12v7 vor 12v4 vor 12v1. Bei diesem Ausführungsbeispiel wird dann, wie im Hinblick auf Fig. 3f deutlich wird, Q1 mit nicht Q2, Q2 mit nicht Q3, Q3 mit nicht Q4, Q4 mit nicht Q5, Q5 mit nicht Q6, Q6 mit nicht Q7 und Q7 mit nicht Q1 verschaltet. Ausgehend von den in Fig. 3d dargestellten Duty-Cyclen ergeben sich dann die in Fig. 3f dargestellten Ausgangssignale. Diese können mit einer ähnlichen Logik basierend auf z. B. zwei Multiplexern entsprechend abgegriffen werden.

Die Ausgangslogik zum Abgreifen der Signale Q1 bis Q7 aus dem Ringoszillator kann beispielsweise per HDL designt sein. Ein entsprechendes Schaltungsbeispiel wird nachfolgend in HDL-Sprache beschrieben:

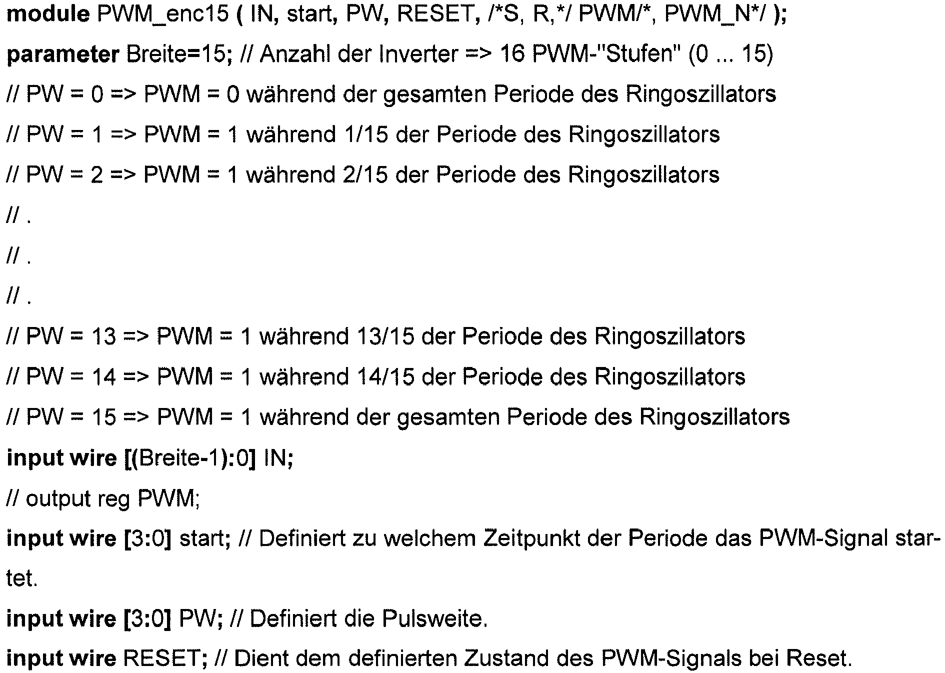

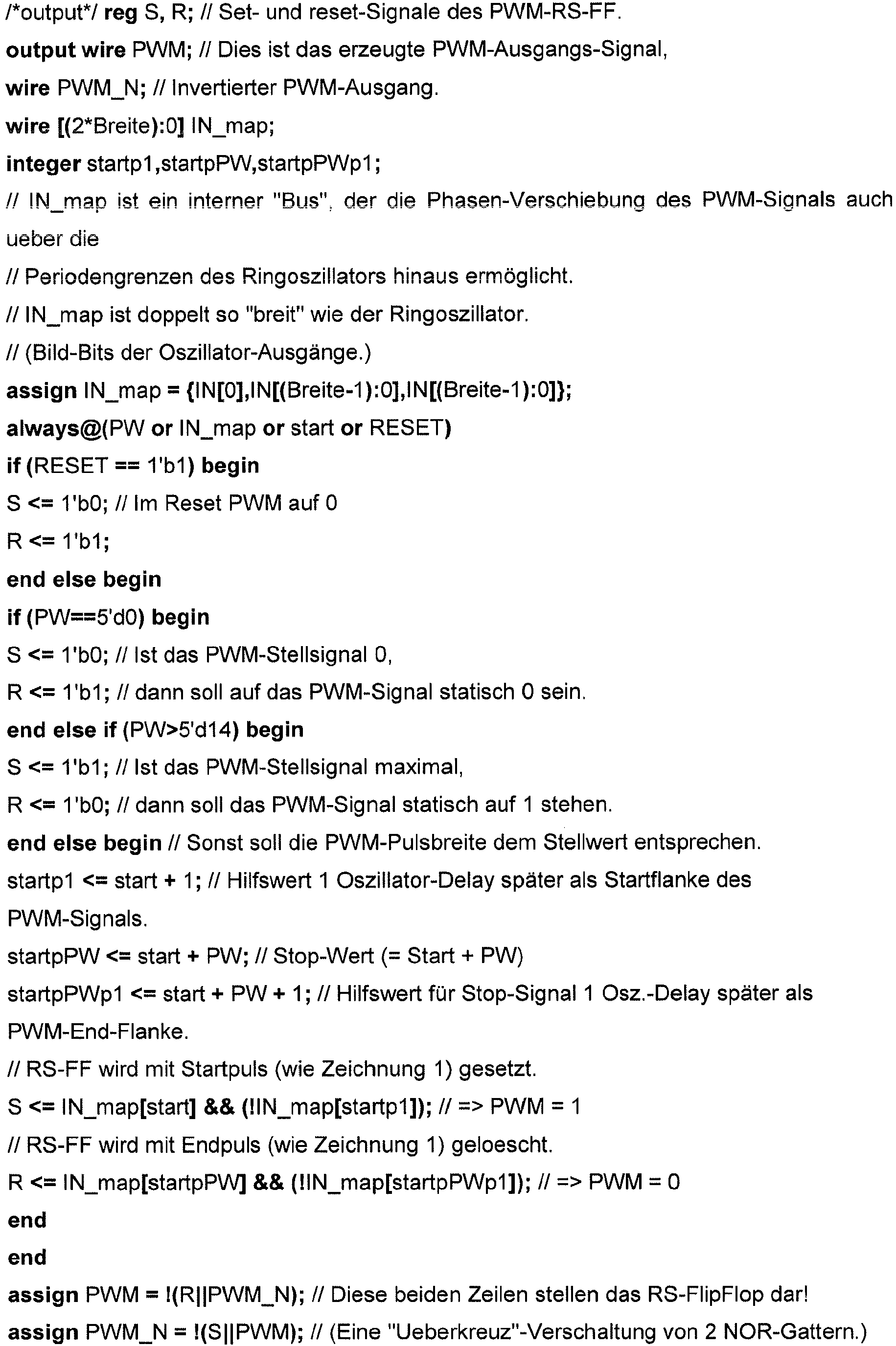

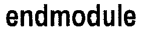

Bezüglich des Ausführungsbeispiels aus Fig. 2a sei angemerkt, dass der Ringoszillator 12' bevorzugterweise synchron zum Systemtakt bzw. zu der Abtastfrequenz des Delta-Sigma-DACs läuft. Hierbei kann beispielsweise eine Synchronisierung durch eine PLL erfolgen, Zum Hintergrund: Der Ring-Oszillator hat eine Eigenfrequenz mit großen Toleranzen (Prozess-Schwankungen, Temperatur, Versorgungs-Spannung). Folglich liegt die Ring-Frequenz liegt ungefähr zwischen 50% und 200% der Nennfrequenz. Sind diese Toleranzen akzeptabel, dann kann einfach ein Ausgangs-Signal des Ringoszillators selbst als Takt für den DSM-DAC verwendet werden. Sind die Toleranzen zu groß (z.B. in Audio-Systemen), dann kann der Ringoszillator
- als VCO (Voltage Controller Oscillator: Versorgungs-Spannung der Inverter wird moduliert),
- CCO (Current Controlled Oscillator: Inverter werden aus einer gemeinsamen Stromquelle versorgt und der Strom wird moduliert)
- DCO (Digitally Controlled Oscillator: Last-Kapazitäten der Inverter sind digital einstellbar)
- in einer PLL (Phase Locked Loop = Phasenregelkreis) betrieben und zum Takt des DSM-DACs synchronisiert werden.

Also kann beispielsweise der Ringoszillator als VCO/DCO verwendet werden. Wird der Systemtakt aus einer separaten Frequenz-Referenz (z.B. ein Quartz) erzeugt, dann ist bevorzugt eine PLL einzusetzen. In diesem Fall kann die Ausgangs-Frequenz des RingOszillators direkt als Takt für den DSM-DAC verwendet werden und gleichzeitig das PWM-Signal aus dem Ring-Oszillator abgeleitet werden.

Alle oben erläuterten Ausführungsbeispiele haben gemein, dass höhere Taktfrequenzen für die Pulsweitenmodulation vermieden werden. Auch wird auf eine zusätzliche Blockdomain in dem PWM-Generator verzichtet. Nachfolgendes Beispiel wird zeigen, dass die Taktfrequenz unabhängig von der Auflösung der PWM ist. Wenn man beispielsweise von einem DSM-Takt von 1 MHz und 8 Bit Auflösung ausgeht, wäre bei einem digitalen Pulsweitenmodulator gemäß dem Stand der Technik F_{CLOCK COUNTER} bei 255 MHz. Entsprechenden neuen Verfahren könnte F_{CLOCK} des Ringoszillators von 1 MHz verwendet werden.

Auch wenn obige Ausführungsbeispiele immer in Zusammenhang mit einer Vorrichtung erläutert wurden, sei darauf hingewiesen, dass weitere Ausführungsbeispiele sich auf ein entsprechendes Ansteuerungsverfahren beziehen. Dieses Verfahren umfasst die Basisschritte des An- und Abwählens der Ausgangssignale der logischen Elemente 12l1 bis 12l7, wie sie beispielsweise in Fig. 3a gezeigt sind. Hierbei werden, z. B. unter Zuhilfenahme ein oder mehrerer Multiplexer die beiden logischen Elemente angewählt bzw. abgewählt, um dann das entsprechende Pulsweitensignal 5p ausgeben zu können. Das An- und Abwählen erfolgt in Abhängigkeit mit dem Multi-Bit-Eingangssignal 5e.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar. Einige oder alle der Verfahrensschritte können durch einen Hardware-Apparat (oder unter Verwendung eines Hardware-Apparats), wie zum Beispiel einen Mikroprozessor, einen programmierbaren Computer oder eine elektronische Schaltung ausgeführt werden. Bei einigen Ausführungsbeispielen können einige oder mehrere der wichtigsten Verfahrensschritte durch einen solchen Apparat ausgeführt werden.

*Ein erfindungsgemäß codiertes Signal, wie beispielsweise ein Audiosignal oder ein Videosignal oder ein Transportstromsignal, kann auf einem digitalen Speichermedium gespeichert sein oder kann auf einem Übertragungsmedium wie beispielsweise einem drahtlosen Übertragungsmedium oder einem verdrahteten Übertragungsmedium, z.B. dem Internet, übertragen werden*

*Das erfindungsgemäße kodierte Audiosignal kann auf einem digitalen Speichermedium gespeichert sein, oder kann auf einem Übertragungsmedium, wie beispielsweise einem drahtlosen Übertragungsmedium oder einem drahtgebundenen Übertragungsmedium, wie beispielsweise dem Internet, übertragen werden.*

Je nach bestimmten Implementierungsanforderungen können Ausführungsbeispiele der Erfindung in Hardware oder in Software implementiert sein. Die Implementierung kann unter Verwendung eines digitalen Speichermediums, beispielsweise einer Floppy-Disk, einer DVD, einer Blu-ray Disc, einer CD, eines ROM, eines PROM, eines EPROM, eines EEPROM oder eines FLASH-Speichers, einer Festplatte oder eines anderen magnetischen oder optischen Speichers durchgeführt werden, auf dem elektronisch lesbare Steuersignale gespeichert sind, die mit einem programmierbaren Computersystem derart zusammenwirken können oder zusammenwirken, dass das jeweilige Verfahren durchgeführt wird. Deshalb kann das digitale Speichermedium computerlesbar sein.

Manche Ausführungsbeispiele gemäß der Erfindung umfassen also einen Datenträger, der elektronisch lesbare Steuersignale aufweist, die in der Lage sind, mit einem programmierbaren Computersystem derart zusammenzuwirken, dass eines der hierin beschriebenen Verfahren durchgeführt wird.

Allgemein können Ausführungsbeispiele der vorliegenden Erfindung als Computerprogrammprodukt mit einem Programmcode implementiert sein, wobei der Programmcode dahingehend wirksam ist, eines der Verfahren durchzuführen, wenn das Computerprogrammprodukt auf einem Computer abläuft.

Der Programmcode kann beispielsweise auch auf einem maschinenlesbaren Träger gespeichert sein.

Andere Ausführungsbeispiele umfassen das Computerprogramm zum Durchführen eines der hierin beschriebenen Verfahren, wobei das Computerprogramm auf einem maschinenlesbaren Träger gespeichert ist.

Mit anderen Worten ist ein Ausführungsbeispiel des erfindungsgemäßen Verfahrens somit ein Computerprogramm, das einen Programmcode zum Durchführen eines der hierin beschriebenen Verfahren aufweist, wenn das Computerprogramm auf einem Computer abläuft.

Ein weiteres Ausführungsbeispiel der erfindungsgemäßen Verfahren ist somit ein Datenträger (oder ein digitales Speichermedium oder ein computerlesbares Medium), auf dem das Computerprogramm zum Durchführen eines der hierin beschriebenen Verfahren aufgezeichnet ist. Der Datenträger, das digitale Speichermedium oder das computerlesbare Medium sind typischerweise gegenständlich und/oder nicht-vergänglich bzw. nichtvorübergehend.

Ein weiteres Ausführungsbeispiel des erfindungsgemäßen Verfahrens ist somit ein Datenstrom oder eine Sequenz von Signalen, der bzw. die das Computerprogramm zum Durchführen eines der hierin beschriebenen Verfahren darstellt bzw. darstellen. Der Datenstrom oder die Sequenz von Signalen kann bzw. können beispielsweise dahingehend konfiguriert sein, über eine Datenkommunikationsverbindung, beispielsweise über das Internet, transferiert zu werden.

Ein weiteres Ausführungsbeispiel umfasst eine Verarbeitungseinrichtung, beispielsweise einen Computer oder ein programmierbares Logikbauelement, die dahingehend konfiguriert oder angepasst ist, eines der hierin beschriebenen Verfahren durchzuführen.

Ein weiteres Ausführungsbeispiel umfasst einen Computer, auf dem das Computerprogramm zum Durchführen eines der hierin beschriebenen Verfahren installiert ist.

Ein weiteres Ausführungsbeispiel gemäß der Erfindung umfasst eine Vorrichtung oder ein System, die bzw. das ausgelegt ist, um ein Computerprogramm zur Durchführung zumindest eines der hierin beschriebenen Verfahren zu einem Empfänger zu übertragen. Die Übertragung kann beispielsweise elektronisch oder optisch erfolgen. Der Empfänger kann beispielsweise ein Computer, ein Mobilgerät, ein Speichergerät oder eine ähnliche Vorrichtung sein. Die Vorrichtung oder das System kann beispielsweise einen Datei-Server zur Übertragung des Computerprogramms zu dem Empfänger umfassen.

Bei manchen Ausführungsbeispielen kann ein programmierbares Logikbauelement (beispielsweise ein feldprogrammierbares Gatterarray, ein FPGA) dazu verwendet werden, manche oder alle Funktionalitäten der hierin beschriebenen Verfahren durchzuführen. Bei manchen Ausführungsbeispielen kann ein feldprogrammierbares Gatterarray mit einem Mikroprozessor zusammenwirken, um eines der hierin beschriebenen Verfahren durchzuführen. Allgemein werden die Verfahren bei einigen Ausführungsbeispielen seitens einer beliebigen Hardwarevorrichtung durchgeführt. Diese kann eine universell einsetzbare Hardware wie ein Computerprozessor (CPU) sein oder für das Verfahren spezifische Hardware, wie beispielsweise ein ASIC.

Die hierin beschriebenen Vorrichtungen können beispielsweise unter Verwendung eines Hardware-Apparats, oder unter Verwendung eines Computers, oder unter Verwendung einer Kombination eines Hardware-Apparats und eines Computers implementiert werden.

Die hierin beschriebenen Vorrichtungen, oder jedwede Komponenten der hierin beschriebenen Vorrichtungen können zumindest teilweise in Hardware und/oder in Software (Computerprogramm) implementiert sein.

Die hierin beschriebenen Verfahren können beispielsweise unter Verwendung eines Hardware-Apparats, oder unter Verwendung eines Computers, oder unter Verwendung einer Kombination eines Hardware-Apparats und eines Computers implementiert werden.

Die hierin beschriebenen Verfahren, oder jedwede Komponenten der hierin beschriebenen Verfahren können zumindest teilweise durch Hardware und/oder durch Software ausgeführt werden.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

## Patentansprüche

1. Schaltung (1) zur Pulsweitenmodulation mit einem Pulsweitenmodulator, wobei der Pulsweitenmodulator folgende Merkmale aufweist:
einen Ringoszillator (12, 12', 12", 12'") mit einer Vielzahl an Verzögerungsgliedern (12v1 - 12v7), wobei jedes Verzögerungsglied (12v1 - 12v7) zumindest ein invertierendes Element aufweist;
eine Ausgangslogik (12l1 - 12l7, 12m1, 12m2), die ausgebildet ist, um in Abhängigkeit von einem Multi-Bit-Signal (5e) Ausgangssignale der invertierenden Element in kombinierter Form abzugreifen, um das pulsweitenmodulierte Signal (5p) bereitzustellen, so dass die Pulsweiten des pulsweitenmodulierten Signals (5p) von dem Multi-Bit-Signal (5e) abhängig sind.

2. Schaltung (1) gemäß Anspruch 1, wobei die Ausgangslogik (12l1 - 12l7, 12m1, 12m2) mindestens ein erstes logisches Element (12l1) aufweist, das ausgebildet ist, zwei Ausgangssignale von einem ersten und einem zweiten der invertierenden Elemente logisch miteinander zu verknüpfen, um ein resultierendes Signal bereitzustellen; oder
wobei die Ausgangslogik (12l1 - 12l7, 12m1, 12m2) mindestens ein erstes logisches Element (12l1) aufweist, das ausgebildet ist, zwei Ausgangssignale von einem ersten und einem zweiten der invertierenden Elemente logisch miteinander zu verknüpfen, um ein resultierendes Signal bereitzustellen und wobei die Ausgangslogik (12l1 - 12l7, 12m1, 12m2) mindestens ein zweites logisches Element aufweist (12l2), das ausgebildet ist, zwei Ausgangssignale von einem zweiten und dritten der invertierendes Element logisch miteinander zu verknüpfen, um ein weiteres resultierendes Signal bereitzustellen.

3. Schaltung (1) gemäß Anspruch 2, wobei das zweite invertierende Element gegenüber dem ersten invertierenden Element ein nachfolgendes oder ein übernächstes invertierendes Element ist.

4. Schaltung (1) gemäß einem der vorherigen Ansprüche, wobei die Ausgangslogik (12l1 - 12l7, 12m1, 12m2) einen Multiplexer (12m1, 12m2) umfasst, der ausgebildet ist, von zumindest zwei logischen Elementen (12l1, 12l2) der Ausgangslogik (12l1 - 12l7, 12m1, 12m2) das resultierende Signal auszuwählen und in kombinierter Form als pulsweitenmoduliertes Signal (5p) bereitzustellen.

5. Schaltung (1) gemäß Anspruch 6, wobei die Auswahl in Abhängigkeit von dem Multi-Bit-Signal (5e) erfolgt.

6. Schaltung (1) gemäß einem der vorherigen Ansprüche, wobei die Ausgangslogik (12l1 - 12l7, 12m1, 12m2) einen weiteren Multiplexer (12m1, 12m2) aufweist, der ausgebildet ist, anliegende resultierende Signale von zumindest einem logischen Element (12l1, 12l2) abzuwählen, um das Pulsweitenmodulierte Signal (5p) bereitzustellen; oder
wobei die Ausgangslogik (12l1 - 12l7, 12m1, 12m2) einen weiteren Multiplexer (12m1, 12m2) aufweist, der ausgebildet ist, anliegende resultierende Signale von zumindest einem logischen Element (12l1, 12l2) abzuwählen, um das Pulsweitenmodulierte Signal (5p) bereitzustellen und wobei die Abwahl abhängig von dem Multi-Bit-Signal (5e) ist.

7. Schaltung (1) gemäß einem der Ansprüche 2 bis 6, wobei das resultierende Signal des ersten logischen Elements (12l1) eine vorgegebene Pulsweite hat und wobei das weitere resultierende Signal des zweiten logischen Elements (12l2) eine vorgegebene Pulsweite hat und gegenüber dem resultierenden Signal des ersten logischen Elements (12l1) phasenversetzt ist, so dass in Abhängigkeit von der Kombination oder der Nicht-Kombination des resultierenden Signals des ersten logischen Elements (12l1) und des weiteren resultierenden Signals des zweiten logischen Elements (12l2) eine Pulsweite des Pulsweitenmodulierten Signals (5p) beeinflussbar ist.

8. Schaltung (1) gemäß einem der vorherigen Ansprüche, die einen Delta-Sigma-Modulator (10, 10', 1s') aufweist, der ausgebildet ist, ein Multi-Bit-Signal (5e) bereitzustellen; oder
die einen Subapproximations-Digital-Analog-Wandler aufweist, der ausgebildet ist, ein Multi-Bit-Signal (5e) bereitzustellen.

9. Schaltung (1) gemäß einem der vorherigen Ansprüche, wobei das invertierende Element einen Inverter, Operationsverstärker, ein NOR-Gatter und/oder ein NAND-Gatter umfasst; oder
wobei das invertierende Element ausgebildet ist, auf Basis eines Eingangssignals ein um (180°) oder um (180° + n x 360°) verschobenen Ausgangssignal bereitzustellen.

10. Schaltung (1) gemäß einem der vorherigen Ansprüche, wobei der Ringoszillator (12, 12', 12", 12"') eine ungerade Zahl an Verzögerungsgliedern (12v1 - 12v7) umfasst.

11. Schaltung (1) gemäß einem der vorherigen Ansprüche, wobei jedes invertierende Element mit einem Kondensator als Verzögerungselement gekoppelt ist.

12. Schaltung (1) gemäß einem der vorherigen Ansprüche, wobei der Ringoszillator (12, 12', 12", 12'") ein Und-Gatter umfasst, über welches das letzte invertierende Element mit dem ersten invertierenden Element gekoppelt ist, wobei das Und-Gatter über ein Enable-Signal gesteuert wird.

13. Schaltung (1) gemäß einem der vorherigen Ansprüche, wobei die Schaltung (1) eine Class-D-Endstufe umfasst, die mit einem Ausgang des Pulsweitenmodulators gekoppelt ist, um durch das pulsweitenmodulierte Signal (5p) betrieben zu werden.

14. Verfahren zur Ansteuerung der Schaltung (1) gemäß einem der vorherigen Ansprüche in Abhängigkeit von dem Multi-Bit-Signal (5e), mit folgenden Schritten:
Auswählen oder Abwählen eines oder mehrerer logischer Elemente (12l1, 12l2) der Ausgangslogik (12l1 - 12l7, 12m1, 12m2), die jeweils ausgebildet sind, zwei Ausgangssignale von einem ersten und einem zweiten der invertierenden Elemente (12l1, 12l2) logisch miteinander zu verknüpfen, um jeweils ein resultierendes Signal bereitzustellen, um in Abhängigkeit von der Auswahl oder Abwahl die resultierenden Signale in Kombination als das pulsweitenmodulierte Signal (5p) bereitzustellen,
wobei die Auswahl oder Abwahl in Abhängigkeit von dem Multi-Bit-Signal (5e) erfolgt.

15. Computerprogramm zur Durchführung des Verfahrens nach Anspruch 14, wenn das Verfahren auf einem Computer abläuft.
